# EUROPEAN PATENT APPLICATION

(11) **EP 4 768 212 A1**
(43) Date of publication of application: **01.07.2026**
(21) Application number: 24906481.7
(22) Date of filing: 19.12.2024
(51) Int. Cl.: B28D 5/04, B28D 5/00, B28D 1/06

(54) **METHOD FOR CUTTING SILICON WAFERS AND SILICON WAFER**

(30) Priority: 19.12.2023 CN 202311754179; 01.07.2024 CN 202410873767; 12.12.2024 CN 202411834779
(71) Applicant: LONGi Green Energy Technology Co., Ltd., Xi'an, Shaanxi 710100 (CN)
(72) Inventor: JIA, Yongjie, Xi'an, Shaanxi 710100 (CN); GUAN, Hui, Xi'an, Shaanxi 710100 (CN); DI, Daming, Xi'an, Shaanxi 710100 (CN); CHENG, Lu, Xi'an, Shaanxi 710100 (CN); YANG, Hao, Xi'an, Shaanxi 710100 (CN); TANG, Chenggui, Xi'an, Shaanxi 710100 (CN); LI, Fanglin, Xi'an, Shaanxi 710100 (CN)
(74) Representative: Grünecker Patent- und Rechtsanwälte PartG mbB
(86) International application number: PCT/CN2024/140759
(87) International publication number: WO 2025/131006

(57) **Abstract**

The present application provides a dicing method for a silicon wafer and a silicon wafer. The dicing method for a silicon wafer includes: providing a silicon rod and a carrier board; driving the silicon rod to move downward relative to dicing wires, to obtain a plurality of silicon wafers by dicing the silicon rod; and lifting the silicon wafers upward relative to the dicing wire, and controlling the dicing wires in contact with the silicon wafers to cyclically move in a forward direction and a reverse direction alternately during the lifting of the silicon wafers. The silicon wafer has a first group of opposite edges and a second group of opposite edges. The first group of opposite edges includes a first edge and a second edge opposite to each other. The second group of opposite edges includes a third edge and a fourth edge opposite to each other. The first edge and/or the second edge intersect with the third edge and/or the fourth edge. A surface of the silicon wafer has two groups of scratches. One group of scratches is inclined toward the third edge in a first direction. The other group of scratches is inclined toward the fourth edge in the first direction. The first direction is a direction from the first edge to the second edge. The present application can reduce a case in which the silicon wafers are dropped when the silicon wafers are lifted upward, and has advantages of a high lifted upward acceleration, high surface quality of the silicon wafers, and a small secondary damage.

## Description

### CROSS-REFERENCE TO RELATED APPLICATIONS

The present application claims priority to Chinese Patent Application No. 2023117541795, filed on December 19, 2023 and entitled "MATERIAL LIFTING METHOD FOR SILICON WAFER, AND SILICON WAFER", claims priority to Chinese Patent Application No. 2024108737679, filed on July 1, 2024 and entitled "DICING METHOD FOR SILICON WAFER", and claims priority to Chinese Patent Application No. 2024118347797, filed on December 12, 2024 and entitled "DICING METHOD FOR SILICON WAFER, AND SILICON WAFER", which are incorporated herein by reference in their entireties.

### TECHNICAL FIELD

The present application relates to the technical field of production of crystalline silicon solar cells, and in particular, to a dicing method for a silicon wafer, and a silicon wafer.

### BACKGROUND

In a process of dicing a silicon wafer, generally, a silicon rod needs to be adhered to a lower surface of a carrier board, and the carrier board is adhered to a lower surface of a crystal holder. Generally, a drive mechanism is used to drive the crystal holder to move the silicon rod relative to dicing wires in an up-to-down direction, so that the dicing wires dice the silicon rod, and the silicon rod is formed into a plurality of silicon wafers. Then, the silicon wafers need to be lifted upward. Specifically, the drive mechanism drives the crystal holder to move upward, to synchronously drive the silicon wafers to rise relative to the dicing wire. The dicing wires move at the same time, so that the silicon wafers are separated from the dicing wire.

In the related art, to lift the silicon wafers upward, a feed table moves upward at a particular speed, and a steel wire simultaneously moves at another constant speed along one direction. The two components move in coordination, so that the silicon wafers obtained through dicing are lifted upward and separated from a wire net.

However, the foregoing manner of lifting the silicon wafers upward easily causes break of the dicing wire, drop of the silicon wafers when the silicon wafers are lifted upward, and scratches on the silicon wafers, and consequently, surface quality of the silicon wafers is reduced.

### SUMMARY

According to a first aspect of the present application, a dicing method for a silicon wafer is provided. The method includes:
providing a silicon rod and a carrier board;
driving the silicon rod to move downward relative to dicing wires, to obtain a plurality of silicon wafers by dicing the silicon rod by using the dicing wire; and
lifting the silicon wafers upward relative to the dicing wire, and controlling the dicing wires in contact with the silicon wafers to cyclically move in a forward direction and a reverse direction alternately during the lifting of the silicon wafers.

In an embodiment, the controlling the dicing wires in contact with the silicon wafers to cyclically move in a forward direction and a reverse direction alternately includes:
in a direction switching phase, controlling the dicing wires to switch a movement direction within 0s to 0.5s, and accelerate to any speed ranging from 0.01 m/s to 1 m/s within 4s to 7s; and
in a non-direction switching phase, controlling the dicing wires to move at any constant speed ranging from 0.01 m/s to 1 m/s.

In an embodiment, a distance by which the dicing wires move in the forward direction and a distance by which the dicing wires move in the reverse direction are the same in each cycle of alternation between the forward direction and the reverse direction.

In an embodiment, a distance by which the dicing wires move in the forward direction or the reverse direction is any value ranging from 0.05 m to 30 m in each cycle of alternation between the forward direction and the reverse direction.

In an embodiment, the lifting the silicon wafers upward includes:
determining a feed speed based on a height by which the silicon wafers are to be lifted upward, where feed speeds corresponding to different lifting heights are at least partially different; and
controlling to lift the silicon wafers upward at the feed speed.

When the foregoing technical solution is used, a friction force formed by the dicing wires on the silicon wafers is affected by a contact area between the dicing wires and the silicon wafers during the upward lifting of the silicon wafers, and the contact area between the dicing wires and the silicon wafers is affected by the height by which the silicon wafers are to be lifted upward. A feed speed at which the silicon wafers are lifted upward is dynamically adjusted based on different heights by which the silicon wafers are to be lifted upward and a situation in which the contact area between the dicing wires and the silicon wafers is affected by the height by which the silicon wafers are to be lifted upward, so that a probabilities of scratches formed by the dicing wires on the silicon wafers at different lifting heights tends to be consistent, thereby reducing the scratches formed by the dicing wires on the silicon wafers, improving a speed at which the silicon wafers are lifted upward, and improving production efficiency.

In an embodiment, before the determining a feed speed based on a height by which the silicon wafers are to be lifted upward, the method further includes:
determining a correspondence between heights by which the silicon wafers are to be lifted upward and feed speeds, where in the correspondence, the feed speeds corresponding to different lifting heights are at least partially different, to homogenize scratches formed by the dicing wires on the silicon wafers when the silicon wafers are controlled to be lifted upward at the feed speed determined based on the correspondence.

The determining a feed speed based on a height by which the silicon wafers are to be lifted upward includes:
determining the feed speed based on the height by which the silicon wafers are to be lifted upward and the correspondence.

In an embodiment, the process of lifting the silicon wafers upward includes a start phase, an intermediate phase, and an end phase in sequence.

The determining a feed speed based on a height by which the silicon wafers are to be lifted upward includes:
controlling a first feed speed of the silicon wafers to be less than a second feed speed of the silicon wafers, where the first feed speed is a speed at which the silicon wafers are lifted upward in the start phase, and the second feed speed is a speed at which the silicon wafers are lifted upward in the intermediate phase; and
controlling a third feed speed of the silicon wafer to be greater than or equal to the second feed speed, where the third feed speed is a speed at which the silicon wafers are lifted upward in the end phase.

In an embodiment, the first feed speed is any speed ranging from 20 mm/min to 40 mm/min, the second feed speed is any speed ranging from 40 mm/min to 80 mm/min, and the third feed speed is any speed ranging from 80 mm/min to 600 mm/min.

In an embodiment, the dicing method for a silicon wafer further includes:
lifting the silicon wafers upward relative to the dicing wire, where a motion mode of the dicing wires when the dicing wires are located inside the carrier board is different from a motion mode of the dicing wires after the dicing wires are separated from the carrier board.

When the foregoing technical solution is used, in the process of lifting the silicon wafers upward relative to the dicing wire, the motion mode of the dicing wires when the dicing wires are located inside the carrier board is different from the motion mode of the dicing wires after the dicing wires are separated from the carrier board. Because materials of the carrier board and the silicon wafers are different, and requirements on protection for the carrier board and protection quality of the silicon wafers are different, a more proper motion mode of the dicing wires are selected based on an actual lifting environment of whether the dicing wires are located inside the carrier board or the dicing wires are located between the silicon wafers, to ensure that a damage caused by the dicing wires to the silicon wafers is reduced.

In an embodiment, that a motion mode of the dicing wires when the dicing wires are located inside the carrier board is different from a motion mode of the dicing wires after the dicing wires are separated from the carrier board includes:
when the dicing wires are located inside the carrier board, the dicing wires move in the forward direction or the reverse direction; and when the dicing wires are separated from the carrier board, the dicing wires cyclically moves in the forward direction and the reverse direction alternately. When the foregoing technical solution is used, when the dicing wires are located inside the carrier board, the dicing wires performs only wire receiving motion or wire releasing motion. In this case, the dicing wires does not swing back and forth in a horizontal direction perpendicular to a surface of the silicon wafer, so that the dicing wires remains at a position at which the carrier board is diced in a dicing process, that is, the dicing wires are not biased to either of two adjacent silicon wafers. In this way, in the process of lifting the silicon wafers upward relative to the dicing wire, the dicing wires does not easily hang up on a side of the silicon wafer that is adhered to the carrier board. Further, a case in which the dicing wires are snapped or the silicon wafers are dropped as the silicon wafers are lifted is effectively reduced. In addition, because the carrier board has a low requirement on protection, the unidirectional motion is selected, to reduce unnecessary switching of a movement direction and improve lifting efficiency of the dicing wires in the carrier board. Then, in a lifting process in which the dicing wires are first separated from the carrier board and then separated from the silicon wafers, the dicing wires alternately performs wire receiving motion and wire releasing motion, and the dicing wires changes, relative to a side on which the silicon wafer enters, as the movement direction of the dicing wires changes. In this way, phenomena that a bow of the dicing wires are large because the dicing wires enters only from one side of the silicon wafer, a friction force suffered by the dicing wires from the silicon wafer is large, and the dicing wires does not easily separate surfaces of two adjacent silicon wafers that are away from the side on which the silicon wafer enters can be reduced, thereby reducing phenomena that scratches and bright lines are caused by friction of the dicing wires on the silicon wafer or even the silicon wafer is dropped because the silicon wafers are not easily separated by the dicing wires due to a large suction force. In addition, when the dicing wires are located between two adjacent silicon wafers, the dicing wires alternately performs wire receiving motion and wire releasing motion, and the dicing wires swings back and forth in the horizontal direction perpendicular to the surface of the silicon wafer. In this case, the dicing wires are not in constant contact with either of the two adjacent silicon wafers, and the dicing wires are out of contact with the silicon wafer in a process of swinging upward in the horizontal direction, thereby reducing a time length of contact between the dicing wires and the silicon wafer, reducing friction on the silicon wafer, reducing a phenomenon of scratches on the surface of the silicon wafer, and reducing snapping of the dicing wires and a damage of the dicing wires to the silicon wafer.

In an embodiment, in a process in which the dicing wires cyclically moves in the forward direction and the reverse direction alternately, the dicing wires alternately moves in the forward direction and the reverse direction, a distance by which the dicing wires move in the forward direction is any value ranging from 0.05 m to 0.2 m, and a distance by which the dicing wires move in the reverse direction is any value ranging from 0.05 m to 0.2 m.

In an embodiment, the distance by which the dicing wires move in the forward direction and the distance by which the dicing wires move in the reverse direction are the same in a process in which the dicing wires alternately moves in the forward direction and the reverse direction.

In an embodiment, when the dicing wires are located inside the carrier board, an average wire moving speed at which the dicing wires move in the forward direction or the reverse direction in a process in which the dicing wires move in the forward direction or the reverse direction is S1.

When the dicing wires are separated from the carrier board, a maximum wire moving speed at which the dicing wires move in the forward direction or the reverse direction in a process in which the dicing wires alternately moves in the forward direction and the reverse direction is S2, and S1 < S2.

In an embodiment, when it is determined that the dicing wires are located inside the carrier board, a wire moving speed of the dicing wires gradually increases in the process in which the dicing wires move in the forward direction or the reverse direction.

In an embodiment, 3 m/min ≤ S1 ≤ 50 m/min, and/or S2 ≤ 50 m/min.

In an embodiment, a speed at which the silicon wafers are lifted upward relative to the dicing wires are any speed ranging from 15 mm/min to 60 mm/min.

According to a second aspect of the present application, a silicon wafer is provided. The silicon wafer has a first group of opposite edges and a second group of opposite edges. The first group of opposite edges includes a first edge and a second edge opposite to each other. The second group of opposite edges includes a third edge and a fourth edge opposite to each other. The first edge and/or the second edge intersect with the third edge and/or the fourth edge. The silicon wafer has two groups of scratches.

One group of scratches is inclined toward the third edge in a first direction. The other group of scratches is inclined toward the fourth edge in the first direction. The first direction is a direction from the first edge to the second edge.

In an embodiment, angles between the scratches and a dicing mark are less than 20°.

In an embodiment, depths of the scratches range from 2 µm to 17 µm.

In an embodiment, the two groups of scratches are located on a same surface of the silicon wafer, and/or the two groups of scratches are respectively located on two opposite surfaces of the silicon wafer.

In comparison with the related art, the embodiments of the present application include the following advantages:
In the embodiments of the present application, in the provided dicing method for a silicon wafer, the silicon rod is first diced by using the dicing wire. After the silicon rod is diced into the silicon wafers, the silicon wafers are controlled to be lifted upward. In a process of controlling to lift the silicon wafers upward, the dicing wires are controlled to cyclically move in the forward direction and the reverse direction alternately. The contact area between the silicon wafer and the dicing wires are smaller due to a feature that a bow when the wire moves in the forward direction and the reverse direction is less than a bow when the wire unidirectionally moves, so that not only a probability that the dicing wires forms the scratches on the silicon wafers during the upward lifting of the silicon wafers, but also a case in which the silicon wafers are dropped when the silicon wafers are lifted upward can be reduced. In addition, there are advantages of a high lifted upward acceleration, high surface quality of the produced silicon wafers, and a small secondary damage. In addition, the different motion modes of the dicing wires when the dicing wires are located inside the carrier board and after the dicing wires are separated from the carrier board are selected based on the actual lifting environment of whether the dicing wires are located inside the carrier board or the dicing wires are located between the silicon wafers, so that the damage of the dicing wires to the silicon wafer is further reduced.

It should be understood that the foregoing general descriptions and the following detailed descriptions are merely for exemplary and explanatory purposes, and cannot limit the present application.

### BRIEF DESCRIPTION OF THE DRAWINGS

The accompanying drawings described herein are used to provide further understanding of the present application, and form a part of the present application. Exemplary embodiments of the present application and descriptions thereof are used to explain the present application, and do not constitute any inappropriate limitation to the present application. In the accompanying drawings:
FIG. 1 is a schematic diagram of a structure during upward lifting of a silicon wafer in the related art;
FIG. 2 is a flowchart of a dicing method for a silicon wafer according to Embodiment 1 of the present application;
FIG. 3 is a schematic diagram of a position relationship between a silicon rod and dicing wires in a process in which the dicing wires dice the silicon rod according to an embodiment of the present application;
FIG. 4 is a schematic diagram of a structure during upward lifting of a silicon wafer according to another embodiment of the present application;
FIG. 5 is a flowchart of a process of lifting a silicon wafer upward according to Embodiment 2 of the present application;
FIG. 6 is a flowchart of a process of lifting a silicon wafer upward according to Embodiment 3 of the present application;
FIG. 7 is a schematic diagram of an enlarged view of a surface of a silicon wafer prepared by using a method according to an embodiment of the present application;
FIG. 8 is a schematic diagram of a position relationship between a silicon wafer and dicing wires when the silicon wafer obtained by dicing a silicon rod is lifted upward relative to the dicing wires and when the dicing wires are partially located inside a carrier board in the embodiment shown in FIG. 4;
FIG. 9 is a schematic diagram of a position relationship between a silicon wafer and dicing wires when the silicon wafer obtained by dicing a silicon rod is lifted upward relative to the dicing wires and after the dicing wires are separated from a carrier board in the embodiment shown in FIG. 4;
FIG. 10 is a diagram of a local structure of a first group of scratches displayed on the silicon wafer according to the embodiment shown in FIG. 4; and
FIG. 11 is a diagram of a local structure of a second group of scratches displayed on the silicon wafer according to the embodiment shown in FIG. 4.

### DETAILED DESCRIPTION

To make the technical problems to be solved by, the technical solutions, and the beneficial effects of the present application clearer and more comprehensible, the following describes the present application in further detail with reference to the accompanying drawings and embodiments. It should be understood that the specific embodiments described herein are merely used for describing the present application and are not intended to limit the present application.

It should be noted that, in the descriptions of the present application, it should be understood that orientation or position relationships indicated by the terms such as "on", "below", "front", "rear", "left", "right", and the like are based on orientation or position relationships shown in the accompanying drawings, and are used only for ease and brevity of illustration of the present application and description, rather than indicating or implying that the mentioned device or element needs to have a particular orientation or needs to be constructed and operated in a particular orientation. Therefore, such terms should not be construed as a limitation to the present application.

In the descriptions of the present application, it should be noted that, unless otherwise explicitly specified or limited, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two components, or an interaction relationship between two components. A person of ordinary skill in the art may understand specific meanings of the terms in the present application according to specific situations.

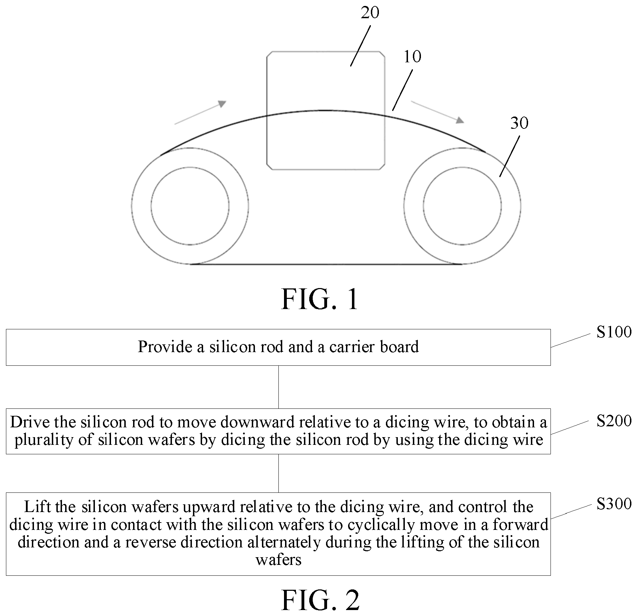

The applicant of the present application finds that, in an existing production technology of a silicon wafer, as shown in FIG. 1, after dicing is completed, a silicon wafer 20 moves upward by using a feed table at a particular speed, and meanwhile, dicing wires 10 moves along a direction at a particular speed. In combination, the diced silicon wafer is lifted from a wire net until a lower surface of the silicon wafer departs from the wire net. During the upward lifting of the silicon wafer, because the wire net carries dicing fluid, and a large absorption force is generated between the wire net and the silicon wafer under a tensile force of the dicing fluid, a steel wire is adsorbed to a surface of the silicon wafer. Therefore, when the silicon wafer is lifted, the steel wire is forced to be stretched to form a reverse bow. As a result, a contact area between the steel wire and the silicon wafer is increased, and a probability that the silicon wafer is dropped because the silicon wafer is separated from a carrier board such as a resin board or a glue stick when the silicon wafer is lifted upward is increased. In addition, the large contact area easily causes scratches to the surface of the silicon wafer, and reduces quality of the surface of the silicon wafer. In addition, the enlarged reverse bow causes the steel wire to be in contact with a lower edge of a mortar tube after being pulled up, and a plurality of parts of the steel wire in the wire net are easily broken. Consequently, a large quantity of scratches are caused on the silicon wafer, and a yield rate is greatly affected. It should be noted that, in the art, that the silicon wafer is lifted upward may also be referred to as material lift.

To resolve the foregoing problem in the embodiments of the present application, according to a first aspect of the present application, a dicing method for a silicon wafer is provided, to reduce scratches caused by dicing wires on a surface of a silicon wafer during the upward lifting of the silicon wafer, thereby improving quality of the silicon wafer.

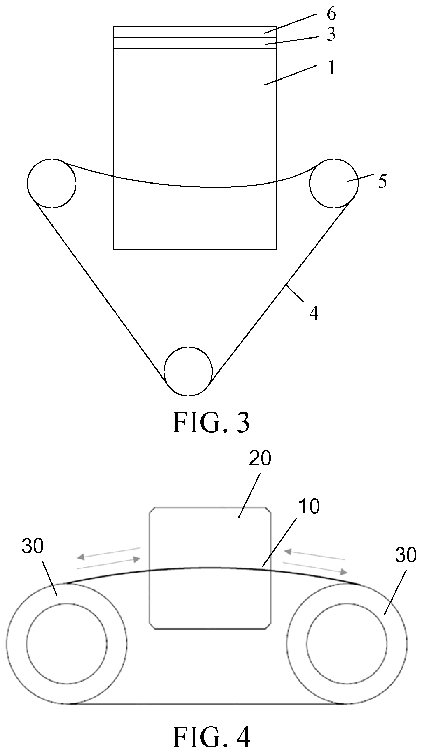

Refer to FIG. 2 and FIG. 3. FIG. 2 is a flowchart of steps of a dicing method for a silicon wafer according to Embodiment 1 of the present application. The method is applied to a process of dicing and upward lifting a silicon wafer, and the method may include step 100 to step 300.

It should be first noted that, as shown in FIG. 3, forward motion or reverse motion of dicing wires 4 is driven by a drive roller 5. During specific implementation, one end of the dicing wires 4 is wrapped from a surface of a first drive roller 5 to a surface of a second drive roller 5, then wrapped to a surface of a third drive roller 5, and then wrapped to the surface of the first drive roller 5, to form dicing wires net in this wrapping manner.

Step S100: Provide a silicon rod 1 and a carrier board 3.

The silicon rod 1 is directly connected to the carrier board 3. First, the carrier board 3 of a corresponding size is selected based on a size of the to-be-diced silicon rod 1. As shown in FIG. 3, the silicon rod is adhered to a lower surface of a crystal holder 6 by using the carrier board 3. During specific implementation, the carrier board 3 may be a resin board or a plastic board. A thickness of the carrier board 3 may be selected based on an actual situation, and is not specifically limited herein.

Step S200: Drive the silicon rod 1 to move downward relative to the dicing wires 4, to obtain a plurality of silicon wafers 2 by dicing the silicon rod 1 by using the dicing wires 4.

It should be noted that, in a process of driving the silicon rod 1 to move downward relative to the dicing wires 4, to obtain the plurality of silicon wafers 2 by dicing the silicon rod 1 by using the dicing wires 4, because there is a bow in the dicing wires 4 in a dicing state, the dicing wires 4 needs to be diced into the carrier board 3 (in this case, the carrier board 3 functions as a sacrificed board) when a back end of the silicon rod is diced, so that the silicon rod 1 is completely diced, and the plurality of silicon wafers are mutually independent. In this case, a state of being completely diced refers to a state in which the silicon wafers 2 are independent of each other and the dicing wires 4 is located in a gap between the silicon wafers 2.

Step S300: Lift the silicon wafers 2 upward relative to the dicing wires 4, and control the dicing wires 4 in contact with the silicon wafers 2 to cyclically move in a forward direction and a reverse direction alternately during the lifting of the silicon wafers 2.

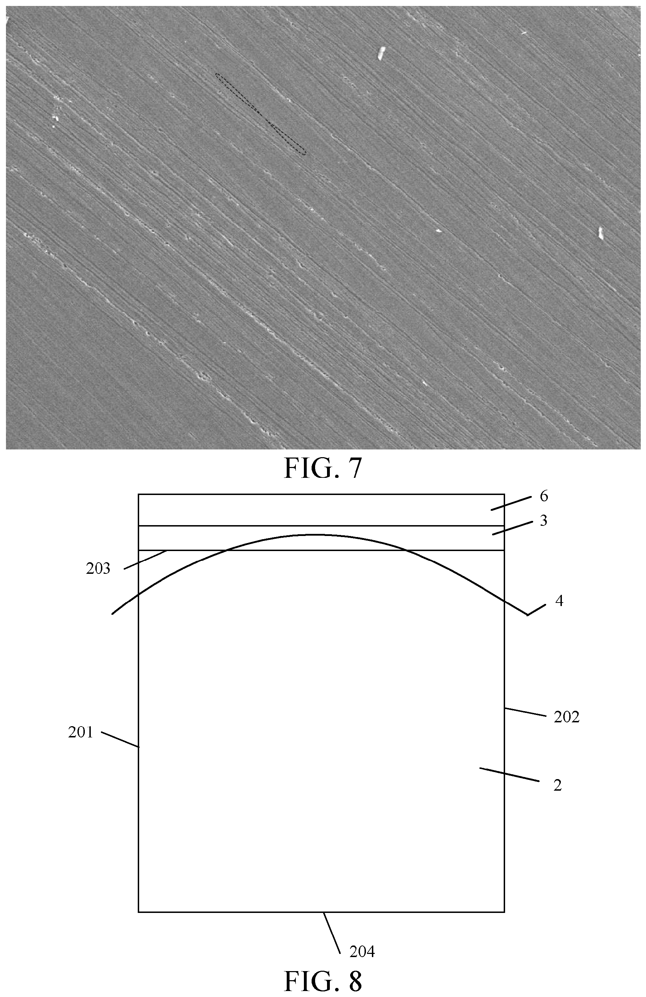

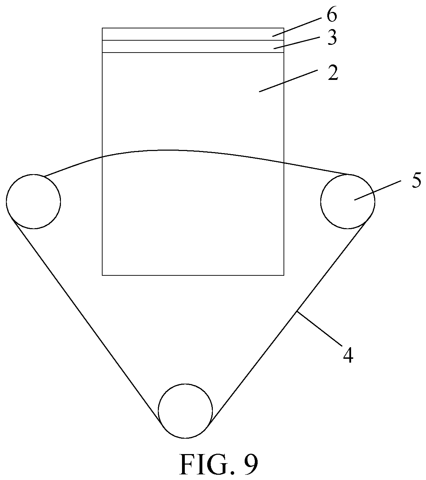

FIG. 8 and FIG. 9 show implementation step S300 in Embodiment 1 of the present application, and FIG. 4 shows another embodiment of implementation step S300 according to the present application. The embodiment shown in FIG. 4 is first described below, and the embodiments shown in FIG. 8 and FIG. 9 are described in detail below.

As shown in FIG. 4, in this embodiment, a dicing apparatus is provided with two drive rollers, that is, main rollers 30. The dicing wires are wrapped from one main roller 30 to the other main roller 30. Rotation of the main rollers 30 can drive dicing wires 10 to move, to dice the silicon rod.

Similarly, after dicing of the silicon rod is completed, because the silicon wafers are still located in the dicing wires net after the silicon rod is diced into the silicon wafers, the silicon wafers need to be separated from the dicing wire. In this case, a feed table is controlled to be lifted upward, to drive the silicon wafers to be lifted upward, so that the dicing wires enters between adjacent silicon wafers again from the resin board until lower surfaces of the silicon wafers are separated from the dicing wires net.

In a process of lifting the silicon wafer 20 upward relative to the dicing wires 10, as shown in FIG. 4, the main rollers 30 on left and right sides are controlled to sequentially serve as an active roller, to control the dicing wires 10 to cyclically move in the forward direction and the reverse direction alternately.

In a unidirectional wire moving process, because the dicing wires are continuously pulled by a force in one direction, deformation formed on the dicing wires are large, and consequently, a large reverse bow is generated. However, during wire moving in the forward direction and the reverse direction, deformation formed by the dicing wires during the upward lifting of the silicon wafer is decomposed in both directions, and as a result, a reverse bow thereof becomes smaller, so that a contact area between the silicon wafer and the dicing wires 10 is smaller. Therefore, not only scratches formed by the dicing wires on a surface of the silicon wafer during the upward lifting of the silicon wafer can be reduced, but also a case in which the silicon wafer is dropped when the silicon wafer is lifted upward can be reduced. There are advantages of a high lifted upward acceleration, high surface quality of the produced silicon wafer, and a small secondary damage.

In an embodiment, in an implementation, the lifting the silicon wafers upward includes step 111 and step 112.

Step 111: Determine a feed speed based on a height by which the silicon wafers are to be lifted upward, where feed speeds corresponding to different lifting heights are at least partially different.

Step 112: Control to lift the silicon wafers upward at the feed speed.

In this implementation, a friction force formed by the dicing wires on the silicon wafers is affected by a contact area between the dicing wires and the silicon wafers during the upward lifting of the silicon wafers, and the contact area between the dicing wires and the silicon wafers is affected by the height by which the silicon wafers are to be lifted upward. A feed speed at which the silicon wafers are lifted upward is dynamically adjusted based on different heights by which the silicon wafers are to be lifted upward and a situation in which the contact area between the dicing wires and the silicon wafers is affected by the height by which the silicon wafers are to be lifted upward, so that a probabilities of scratches formed by the dicing wires on the silicon wafers at different lifting heights tends to be consistent, thereby reducing the scratches formed by the dicing wires on the silicon wafers, improving a speed at which the silicon wafers are lifted upward, and improving production efficiency.

In an embodiment, in a specific implementation, the process of lifting the silicon wafers upward includes a start phase, an intermediate phase, and an end phase in sequence.

Step 111 specifically includes:
controlling a first feed speed of the silicon wafers to be less than a second feed speed of the silicon wafers, where the first feed speed is a speed at which the silicon wafers are lifted upward in the start phase, and the second feed speed is a speed at which the silicon wafers are lifted upward in the intermediate phase; and
controlling a third feed speed of the silicon wafer to be greater than or equal to the second feed speed, where the third feed speed is a speed at which the silicon wafers are lifted upward in the end phase.

In this specific implementation, the start phase is a phase in which the dicing wires starts to enter the silicon wafer from the resin board to which the silicon wafer is adhered, until the dicing wires completely enters the silicon wafer. The intermediate phase is a phase in which the dicing wires are completely located in the silicon wafer. The end phase is a phase in which the dicing wires starts to leave the silicon wafer, until the dicing wires completely leaves the silicon wafer. Using a silicon wafer whose size is 182 mm * 182 mm as an example, a phase in which a height difference between a top of the main roller and a bottom of the silicon wafer ranges from 194 mm to 150 mm is the start phase, a phase in which the height difference between the top of the main roller and the bottom of the silicon wafer ranges from 150 mm to -5 mm is the intermediate phase, and a phase in which the height difference between the top of the main roller and the bottom of the silicon wafer ranges from -5 mm to -20 mm is the end phase.

It should be noted that, in this embodiment, the bottom of the silicon wafer refers to a side of the silicon wafer that is opposite to a side close to the resin board. The top of the main roller herein refers to an uppermost edge of the main roller or the dicing wires net. In other words, the height difference between the top of the main roller and the bottom of the silicon wafer may be understood as a height difference between the dicing wires net and the bottom of the silicon wafer.

In this specific implementation, when the dicing wires enters the silicon wafer from the resin board, a speed at which the silicon wafer is lifted upward is slow, so that side surface of the silicon wafer can be protected. In this case, because the contact area between the dicing wires and the silicon wafer becomes smaller in the end phase, the lifting speed is controlled to be fast, so that not only scratches can be reduced, but also overall duration required when the silicon wafer is lifted upward can be reduced, and efficiency of lifting the silicon wafer upward is improved.

In an embodiment, in a specific implementation, the first feed speed may be any speed ranging from 20 mm/min to 40 mm/min, the second feed speed may be any speed ranging from 40 mm/min to 80 mm/min, and the third feed speed may be any speed ranging from 80 mm/min to 600 mm/min.

For example, the first feed speed may be one of or a value between any two of 20 mm/min, 25 mm/min, 30 mm/min, 35 mm/min, and 40 mm/min. The second feed speed may be one of or a value between any two of 40 mm/min, 45 mm/min, 50 mm/min, 55 mm/min, 60 mm/min, 70 mm/min, and 80 mm/min. The third feed speed may be one of or a value between any two of 80 mm/min, 100 mm/min, 150 mm/min, 200 mm/min, 250 mm/min, 300 mm/min, 350 mm/min, 400 mm/min, 450 mm/min, 500 mm/min, 550 mm/min, and 600 mm/min.

In an embodiment, the dicing method for a silicon wafer provided in this embodiment of the present application further includes:
in a process in which the dicing wires are controlled to cyclically move in the forward direction and the reverse direction alternately, spraying dicing fluid to a contact region between the silicon wafer and the dicing wire.

The dicing fluid is sprayed to contact regions between two sides of the silicon wafer and the dicing wires when the silicon wafer is lifted upward, so that the dicing fluid is brought between adjacent silicon wafers by the dicing wires in a process in which the dicing wires move in the forward direction and the reverse direction, thereby performing lubricating by using the dicing fluid, and further reducing a friction force between the dicing wires and the silicon wafer.

In an embodiment, in an implementation, a flow rate of the dicing fluid may be set to any value ranging from 100 kg/min to 300 kg/min, for example, may be one of or a value between any two of 100 kg/min, 150 kg/min, 200 kg/min, 250 kg/min, and 300 kg/min. In some implementations, the flow rate of the dicing fluid is set to any value ranging from 200 kg/min to 250 kg/min.

In an embodiment, in an implementation, a fluid temperature of the dicing fluid is set to any value ranging from 15 °C to 25 °C, so that functions of a disperser and a lubricant in the dicing fluid can work better, thereby improving a lubricating effect. For example, the fluid temperature of the dicing fluid may be set to one of or a value between any two of 15 °C, 16 °C, 17 °C, 18 °C, 19 °C, 20 °C, 21 °C, 22 °C, 23 °C, 24 °C, and 25 °C. In some implementations, the fluid temperature of the dicing fluid is set to any value ranging from 18 °C to 20 °C.

In this embodiment of the present application, during the upward lifting of the silicon wafers, the dicing wires are controlled to cyclically move in the forward direction and the reverse direction alternately, so that problems of dropping of the silicon wafers and the scratches on the silicon wafers that are easily caused in the existing manner of lifting the silicon wafers upward can be effectively relieved.

The present application further provides a silicon wafer. The silicon wafer is obtained through processing by using the foregoing dicing method for a silicon wafer.

During the upward lifting of the silicon wafer to prepare the foregoing silicon wafer, a manner in which dicing wires cyclically moves in a forward direction and a reverse direction alternately is used, so that a reverse bow formed by the dicing wires can be reduced. Therefore, a contact area between the silicon wafer and the dicing wires are smaller, so that scratches caused by the dicing wires to a surface of the silicon wafer during the upward lifting of the silicon wafer can be significantly reduced, surface quality of the prepared silicon wafer is high, and a secondary damage is small.

### Embodiment 2

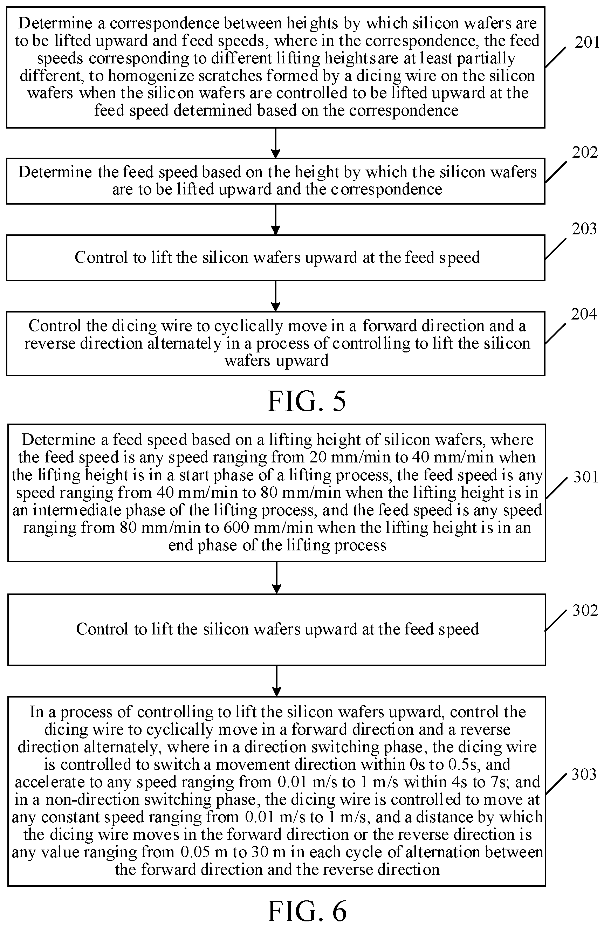

FIG. 5 is a flowchart of steps of a dicing method for a silicon wafer according to Embodiment 2 of the present application. The method is applied to a process of lifting silicon wafers upward, and the method may include step 201 to step 204.

Step 201: Determine a correspondence between heights by which the silicon wafers are to be lifted upward and feed speeds, where in the correspondence, the feed speeds corresponding to different lifting heights are at least partially different, to homogenize scratches formed by dicing wires on the silicon wafers when the silicon wafers are controlled to be lifted upward at the feed speed determined based on the correspondence.

In this step, a probability that the dicing wires forms the scratches on the silicon wafers during the upward lifting of the silicon wafers is affected by a contact area, and the contact area between the dicing wires and the silicon wafers changes with the different heights by which the silicon wafers are to be lifted upward. A lifting speed that constantly changes with the height by which the silicon wafers are to be lifted upward and that is for controlling to homogenize the scratches formed by the dicing wires on the silicon wafers during the upward lifting of the silicon wafers is calculated in advance, that is, the foregoing correspondence is determined.

Step 202: Determine the feed speed based on the height by which the silicon wafers are to be lifted upward and the correspondence.

In this step, the foregoing correspondence stipulates feed speeds of the silicon wafers that correspond to the different lifting heights. In addition, when the silicon wafers are controlled to be lifted upward at the feed speed determined based on the correspondence during the upward lifting of the silicon wafers, a size of a reverse bow formed by the dicing wires tends to be uniform. Therefore, when the silicon wafers are controlled to be lifted upward at the foregoing feed speed, the scratches formed by the dicing wires on the silicon wafers tend to be uniform, and a difference between the scratches is small, so that the silicon wafers are not easily dropped, and quality of the silicon wafers is higher.

Step 203: Control to lift the silicon wafers upward at the feed speed.

For details of this step, refer to the foregoing step 112, and details are not described herein again.

Step 204: In a process of controlling to lift the silicon wafers upward, control the dicing wires to cyclically move in a forward direction and a reverse direction alternately.

For details of this step, refer to the foregoing step 102, and details are not described herein again.

In an embodiment, in an implementation, in step 204, the controlling the dicing wires to move in a forward direction and a reverse direction alternately includes step 2041 and step 2042.

Step 2041: In a direction switching phase, control the dicing wires to switch a movement direction within 0s to 0.5s, and accelerate to any speed ranging from 0.01 m/s to 1 m/s within 4s to 7s.

In step 2041, the direction switching phase refers to a process in which an active roller is changed to switch the dicing wires from movement in the forward direction to movement in the reverse direction, or switch the dicing wires from movement in the reverse direction to movement in the forward direction. In the direction switching phase, within short duration ranging from 0s to 0.5s, the dicing wires are controlled to stop moving in an original movement direction, start moving in a movement opposite to the original movement direction, and be accelerated to any speed ranging from 0.01 m/s to 1 m/s within duration ranging from 4s to 7s. Therefore, not only the reverse bow can be effectively reduced, but also load of rotating an electric motor by a drive roller can be prevented from be increased.

Step 2042: In a non-direction switching phase, control the dicing wires to move at any constant speed ranging from 0.01 m/s to 1 m/s.

In step 2042, in the non-direction switching phase, the dicing wires are controlled to move at any constant speed ranging from 0.01 m/s to 1 m/s, so that a lifting rate of the silicon wafer can be well cooperated with, to avoid forming of horizontal scratches or vertical scratches.

In an embodiment, in a specific implementation, a distance by which the dicing wires move in the forward direction and a distance by which the dicing wires move in the reverse direction are the same in each cycle of alternation between the forward direction and the reverse direction, to more evenly offset scratches on the silicon wafers that are caused during movement in the forward direction and the reverse direction, thereby further improving the quality of the silicon wafers.

In an embodiment, in a specific implementation, a distance by which the dicing wires move in the forward direction or the reverse direction is any value ranging from 0.05 m to 30 m in each cycle of alternation between the forward direction and the reverse direction. Therefore, not only the reverse bow of the dicing wires can be reduced, but also the dicing wires can be brought into the silicon wafer by fully using wire moving of the dicing wires in the forward direction and the reverse direction, so that the contact area between the dicing wires and the silicon wafer is effectively reduced, thereby reducing the scratches on the surface of the silicon wafer.

In an embodiment, in some implementations, the distance by which the dicing wires move in the single direction in each cycle of alternation between the forward direction and the reverse direction may be one of or a value between any two of 0.05 m, 0.1 m, 0.2 m, 0.4 m, 0.6 m, 0.8 m, 1 m, 1.2 m, 1.5 m, 1.8 m, 2 m, 2.2 m, 2.5 m, 2.8 m, 3 m, 5 m, 8 m, 10 m, 15 m, 20 m, 25 m, and 30 m.

In this embodiment of the present application, a wire moving distance, a wire moving speed, and acceleration and deceleration duration of the dicing wires in the forward direction and the reverse direction are controlled to control a direction switching frequency of the dicing wire, and speeds of the feed table at different lifting heights are matched, so that a bow formed when the dicing wires are clamped by the silicon wafers is smaller, the contact area between the silicon wafer and the dicing wires are smaller, and the scratches on the surface of the silicon wafer is positively affected.

### Embodiment 3

FIG. 6 is a flowchart of steps of a dicing method for a silicon wafer according to Embodiment 3 of the present application. The method is applied to a process of lifting silicon wafers upward, and the process of lifting the silicon wafers upward includes a start phase, an intermediate phase, and an end phase in sequence.

The method may include step 301 to step 304.

Step 301: Determine a feed speed based on a lifting height of the silicon wafers, where the feed speed is any speed ranging from 20 mm/min to 40 mm/min when the lifting height is in the start phase of the lifting process, the feed speed is any speed ranging from 40 mm/min to 80 mm/min when the lifting height is in the intermediate phase of the lifting process, and the feed speed is any speed ranging from 80 mm/min to 600 mm/min when the lifting height is in the end phase of the lifting process.

For details of this step, refer to the foregoing step 111, and details are not described herein again.

Step 302: Control to lift the silicon wafers upward at the feed speed.

For details of this step, refer to the foregoing step 112, and details are not described herein again.

Step 303: In a process of controlling to lift the silicon wafers upward, control the dicing wires to cyclically move in a forward direction and a reverse direction alternately, where in a direction switching phase, the dicing wires are controlled to switch a movement direction within 0s to 0.5s, and accelerate to any speed ranging from 0.01 m/s to 1 m/s within 4s to 7s; and in a non-direction switching phase, the dicing wires are controlled to move at any constant speed ranging from 0.01 m/s to 1 m/s, and a distance by which the dicing wires move in the forward direction or the reverse direction is any value ranging from 0.05 m to 30 m in each cycle of alternation between the forward direction and the reverse direction.

For details of this step, refer to the foregoing step 204, and details are not described herein again.

In this embodiment of the present application, a wire moving distance, a wire moving speed, and acceleration and deceleration duration of the dicing wires in the forward direction and the reverse direction are controlled, and speeds of the feed table at different lifting heights are matched, so that a bow formed when the dicing wires are clamped by the silicon wafers is smaller, the contact area between the silicon wafer and the dicing wires are smaller, and a probability of scratches formed on the surface of the silicon wafer can be more significantly reduced.

To make the invention objectives, technical solutions, and beneficial effects of the present application clearer, the present application is further described below with reference to the embodiments. It should be understood that the embodiments are only used to describe the present application, and are not intended to limit the scope of the present application.

### Embodiment 1

After dicing of a silicon wafer M10 is completed, based on a height by which the silicon wafer is to be lifted upward and parameters shown in Table 1, the silicon wafer is controlled to rise, a steel wire serving as dicing wires is controlled to cyclically move in a forward direction and a reverse direction alternately, and dicing fluid is sprayed to two sides of the silicon wafer, to lift the diced silicon wafer from a wire net until a lower surface of the silicon wafer departs from the wire net, to obtain the silicon wafer.

**Table 1**

| Position (mm) | Feed speed (mm/min) | Speed of the steel wire (m/s) | Acceleration duration (s) | Forward distance (m) | Reverse distance (m) |
|---|---|---|---|---|---|
| 194 to 150 | 20 | 0.01 | 4 | 0.6 | 0.6 |
| 150 to 100 | 40 | 0.01 | 4 | 0.6 | 0.6 |
| 100 to 50 | 40 | 0.01 | 4 | 0.6 | 0.6 |
| 50 to 30 | 40 | 0.01 | 4 | 0.6 | 0.6 |
| 30 to -5 | 40 | 0.01 | 4 | 0.6 | 0.6 |
| -5 to -20 | 300 | 0.01 | 4 | 0.6 | 0.6 |

### Embodiment 2

After dicing of a silicon wafer M10 is completed, based on a height by which the silicon wafer is to be lifted upward and parameters shown in Table 2, the silicon wafer is controlled to rise, a steel wire serving as dicing wires is controlled to cyclically move in a forward direction and a reverse direction alternately, and dicing fluid is sprayed to two sides of the silicon wafer, to lift the diced silicon wafer from a wire net until a lower surface of the silicon wafer departs from the wire net, to obtain the silicon wafer.

**Table 2**

| Position (mm) | Feed speed (mm/min) | Speed of the steel wire (m/s) | Acceleration duration (s) | Forward distance (m) | Reverse distance (m) |
|---|---|---|---|---|---|
| 194 to 150 | 40 | 1 | 7 | 30 | 30 |
| 150 to 100 | 60 | 1 | 7 | 30 | 30 |
| 100 to 50 | 60 | 1 | 7 | 30 | 30 |
| 50 to 30 | 60 | 1 | 7 | 30 | 30 |
| 30 to -5 | 60 | 1 | 7 | 30 | 30 |
| -5 to -20 | 600 | 1 | 7 | 30 | 30 |

### Embodiment 3

After dicing of a silicon wafer M10 is completed, based on a height by which the silicon wafer is to be lifted upward and parameters shown in Table 3, the silicon wafer is controlled to rise, a steel wire serving as dicing wires is controlled to cyclically move in a forward direction and a reverse direction alternately, and dicing fluid is sprayed to two sides of the silicon wafer, to lift the diced silicon wafer from a wire net until a lower surface of the silicon wafer departs from the wire net, to obtain the silicon wafer.

**Table 3**

| Position (mm) | Feed speed (mm/min) | Speed of the steel wire (m/s) | Acceleration duration (s) | Forward distance (m) | Reverse distance (m) |
|---|---|---|---|---|---|
| 194 to 150 | 30 | 0.5 | 5.5 | 15 | 15 |
| 150 to 100 | 50 | 0.5 | 5.5 | 15 | 15 |
| 100 to 50 | 50 | 0.5 | 5.5 | 15 | 15 |
| 50 to 30 | 50 | 0.5 | 5.5 | 15 | 15 |
| 30 to -5 | 50 | 0.5 | 5.5 | 15 | 15 |
| -5 to -20 | 450 | 0.5 | 5.5 | 15 | 15 |

### Embodiment 4

After dicing of a silicon wafer M10 is completed, based on a height by which the silicon wafer is to be lifted upward and parameters shown in Table 4, the silicon wafer is controlled to rise, a steel wire serving as dicing wires is controlled to cyclically move in a forward direction and a reverse direction alternately, and dicing fluid is sprayed to two sides of the silicon wafer, to lift the diced silicon wafer from a wire net until a lower surface of the silicon wafer departs from the wire net, to obtain the silicon wafer.

**Table 4**

| Position (mm) | Feed speed (mm/min) | Speed of the steel wire (m/s) | Acceleration duration (s) | Forward distance (m) | Reverse distance (m) |
|---|---|---|---|---|---|
| 194 to 150 | 30 | 0.5 | 5.5 | 20 | 10 |
| 150 to 100 | 50 | 0.5 | 5.5 | 20 | 10 |
| 100 to 50 | 50 | 0.5 | 5.5 | 20 | 10 |
| 50 to 30 | 50 | 0.5 | 5.5 | 20 | 10 |
| 30 to -5 | 50 | 0.5 | 5.5 | 20 | 10 |
| -5 to -20 | 450 | 0.5 | 5.5 | 20 | 10 |

### Comparative example 1

After dicing of a silicon wafer M10 is completed, based on a height by which the silicon wafer is to be lifted upward and parameters shown in Table 5, the silicon wafer is controlled to rise, a steel wire serving as dicing wires is controlled to unidirectionally move, and dicing fluid is sprayed to two sides of the silicon wafer, to lift the diced silicon wafer from a wire net until a lower surface of the silicon wafer departs from the wire net, to obtain the silicon wafer.

**Table 5**

| Position (mm) | Feed speed (mm/min) | Speed of the steel wire (m/s) |
|---|---|---|
| 194 to 150 | 30 | 0.2 |
| 150 to 100 | 50 | 0.2 |
| 100 to 50 | 50 | 0.2 |
| 50 to 30 | 50 | 0.2 |
| 30 to -5 | 50 | 0.2 |
| -5 to -20 | 450 | 0.2 |

Scratches on the silicon wafers prepared in Embodiment 1 to Embodiment 4 and Comparative example 1 are respectively tested, and results thereof are shown in Table 6.

**Table 6**

| Group | Scratch |
|---|---|
| Embodiment 1 | 0.83% |
| Embodiment 2 | 1.9% |
| Embodiment 3 | 0.49% |
| Embodiment 4 | 0.62% |
| Comparative example 1 | 3.1% |

The experiments show that, in comparison with a conventional process in which the dicing wires are controlled to unidirectionally move, in this embodiment of the present application, the dicing wires are controlled to cyclically move in the forward direction and the reverse direction alternately during upward movement of the silicon wafer, so that the scratches on the surface of the prepared silicon wafer are obviously less than the scratches on the surface of the silicon wafer that is prepared in the conventional process. It indicates that the method provided in this embodiment of the present application can effectively reduce the scratches formed on the surface of the silicon wafer during the upward lifting of the silicon wafer, and significantly improve quality of the silicon wafer.

In addition, as shown in FIG. 7, the scratches are distributed along a wire moving direction of dicing wires net on the surface of the silicon wafer prepared by using the method provided in this embodiment of the present application, and depths of the scratches range from 2 µm to 10 µm. In comparison with a line mark, the depths of the scratches are significantly small. Such depth control avoids impact of an excessively deep scratch on subsequent processing, so that a high-quality surface of the silicon wafer can be obtained when it is ensured that efficiency is improved. In addition, in a dicing process, the silicon wafer is lifted in a reciprocal wire moving manner, so that particular patterns in which scratches and line marks overlap with each other are formed on the surface of the silicon wafer. These patterns present textures similar to "8" as shown by black dashed lines in FIG. 7. Such patterns are evenly and symmetrically distributed, show high consistency and regularity, and provide high quality guarantee for mass production of the silicon wafer.

As described above, referring to FIG. 3, in a dicing process of the silicon wafer 2, the dicing wires 4 needs to be diced into the carrier board 3. Based on this, as shown in FIG. 8 and FIG. 9, during the upward lifting of the silicon wafer, there are a motion mode of the dicing wires 4 when the dicing wires 4 is located inside the carrier board 3, and a motion mode of the dicing wires 4 after the dicing wires 4 is separated from the carrier board 3. It should be noted that the motion mode of the dicing wires 4 actually refers to a wire moving direction of the dicing wire. To be specific, the dicing wires performs only unidirectional motion in the forward direction or the reverse direction, or perform bidirectional motion in the forward direction and the reverse direction alternately. It should be noted that, in the art, the motion in the forward direction may also be referred to as wire receiving motion, and the motion in the reverse direction may also be referred to as wire releasing motion. Alternatively, the motion in the forward direction may also be referred to as wire releasing motion, and the motion in the reverse direction may also be referred to as wire receiving motion.

In this way, in the process of lifting the silicon wafers upward relative to the dicing wire, the motion mode of the dicing wires when the dicing wires are located inside the carrier board is different from the motion mode of the dicing wires after the dicing wires are separated from the carrier board. Because materials of the carrier board and the silicon wafers are different, and requirements on protection for the carrier board and protection quality of the silicon wafers are different, a more proper motion mode of the dicing wires are selected based on an actual lifting environment of whether the dicing wires are located inside the carrier board or the dicing wires are located between the silicon wafers, and the motion mode of the dicing wires when the dicing wires are located inside the carrier board and the motion mode of the dicing wires after the dicing wires are separated from the carrier board is selected based on an actual situation, to ensure that a damage caused by the dicing wires to the silicon wafers is reduced. In an example, in step S300, that a motion mode of the dicing wires 4 when the dicing wires 4 is located inside the carrier board 3 is different from a motion mode of the dicing wires 4 after the dicing wires 4 is separated from the carrier board 3 specifically including the following steps.

Step S310: When it is determined that the dicing wires 4 is located inside the carrier board 3, the dicing wires 4 moves in the forward direction or the reverse direction.

Step S320: When it is determined that the dicing wires 4 is separated from the carrier board, the dicing wires 4 moves in the forward direction and the reverse direction alternately.

In this way, when the dicing wires 4 is located inside the carrier board 3, the dicing wires 4 performs only unidirectional motion of the motion in the forward direction or the motion in the reverse direction. In this case, the dicing wires 4 does not swing back and forth in a horizontal direction perpendicular to a surface of the silicon wafer, so that the dicing wires 4 remains at a position at which the carrier board 3 is diced in a dicing process, that is, the dicing wires 4 is not biased to either of two adjacent silicon wafers 2. In this way, in the process of lifting the silicon wafers 2 upward relative to the dicing wires 4, the dicing wires 4 does not easily hang up on a side of the silicon wafer 2 that is adhered to the carrier board 3. Further, a case in which the dicing wires 4 is snapped or the silicon wafers 2 are dropped as the silicon wafers 2 are lifted is effectively reduced. In addition, because the carrier board has a low requirement on protection, the unidirectional motion is selected, to reduce unnecessary switching of a movement direction and improve lifting efficiency of the dicing wires in the carrier board. Then, in a lifting process in which the dicing wires 4 is first separated from the carrier board 3 and then separated from the silicon wafers 2, the dicing wires 4 alternately moves in the forward direction and the reverse direction, and the dicing wires 4 changes, relative to a side on which the silicon wafer 2 enters, as the movement direction of the dicing wires 4 changes. In this way, phenomena that a bow of the dicing wires 4 is large because the dicing wires 4 enters only from one side of the silicon wafer 2, a friction force suffered by the dicing wires 4 from the silicon wafer 2 is large, and the dicing wires 4 does not easily separate surfaces of two adjacent silicon wafers 2 that are away from the side on which the silicon wafer 2 enters can be reduced, thereby reducing phenomena that scratches and bright lines are caused by friction of the dicing wires 4 on the silicon wafer 2 or even the silicon wafer 2 is dropped because the silicon wafers 2 are not easily separated by the dicing wires 4 due to a large suction force. In addition, when the dicing wires 4 is located between two adjacent silicon wafers 2, the dicing wires 4 alternately performs the motion in the forward direction and the motion in the reverse direction, and the dicing wires 4 swings back and forth in the horizontal direction perpendicular to the surface of the silicon wafer. In this case, the dicing wires 4 is not in constant contact with either of the two adjacent silicon wafers 2, and the dicing wires 4 is out of contact with the silicon wafer 2 in a process of swinging upward in the horizontal direction, thereby reducing a time length of contact between the dicing wires 4 and the silicon wafer 2, reducing friction on the silicon wafer 2, reducing a phenomenon of scratches on the surface of the silicon wafer 2, and reducing a damage of the dicing wires to the silicon wafer.

As shown in FIG. 9, in a possible implementation, in step S320, in a process in which the dicing wires move in the forward direction and the reverse direction alternately when it is determined that the dicing wires are separated from the carrier board, a distance by which the dicing wires 4 moves in the forward direction is any value ranging from 0.05 m to 0.2 m, and a distance by which the dicing wires 4 moves in the reverse direction is any value ranging from 0.05 m to 0.2 m.

In this way, a case in which the bow of the dicing wires 4 is large because the distance by which the dicing wires 4 moves in the forward direction and the distance by which the dicing wires 4 moves in the reverse direction are long is avoided, thereby reducing the contact area between the dicing wires 4 and the silicon wafer 2, reducing the friction force between the dicing wires 4 and the silicon wafer 2, further reducing a case in which the dicing wires 4 causes a large quantity of scratches to the silicon wafer 2, and reducing the damage caused by the dicing wires to the silicon wafer.

For example, the distance by which the dicing wires 4 moves in the forward direction may be 0.05 m, 0.08 m, 0.1 m, 0.12 m, 0.15 m, 0.18 m, 0.2 m, or the like, and the distance by which the dicing wires 4 moves in the reverse direction may be 0.05 m, 0.06 m, 0.08 m, 0.1 m, 0.12 m, 0.16 m, 0.17 m, 0.2 m, or the like. Certainly, descriptions are merely provided herein as examples, and are not specifically limited.

In an example, in step S320, in the process in which the dicing wires 4 moves in the forward direction and the reverse direction alternately when it is determined that the dicing wires 4 is separated from the carrier board 3, the distance by which the dicing wires 4 moves in the forward direction and the distance by which the dicing wires 4 moves in the reverse direction are the same. In this case, the two adjacent silicon wafers 2 are evenly separated, to avoid a slow speed of separating one side of the silicon wafer 2 parallel to the dicing wires from the other side, reduce the friction force between the silicon wafer and the dicing wires 4, and reduce a phenomenon of scratches on the silicon wafer 2.

In some embodiments, in step S310, in a process in which the dicing wires 4 moves in the forward direction or the reverse direction when it is determined that the dicing wires 4 is located inside the carrier board 3, a wire moving speed at which the dicing wires 4 moves in the forward direction or the reverse direction is S1. In step S320, in the process in which the dicing wires 4 moves in the forward direction and the reverse direction alternately when it is determined that the dicing wires 4 is separated from the carrier board 3, a maximum wire moving speed at which the dicing wires 4 moves in the forward direction or the reverse direction is S2. S1 < S2. In this case, in the process in which the dicing wires move in the forward direction or the reverse direction when it is determined that the dicing wires 4 is located inside the carrier board 3 in step S310, the wire moving speed of the dicing wires 4 is smaller, to avoid a case in which the dicing wires 4 is biased to either of two adjacent silicon wafers 2 due to sway, thereby further reducing occurrence of a case in which the dicing wires 4 hangs up on a side of the silicon wafer 2 that is adhered to the carrier board 3. However, in a lifting process starting from separation of the dicing wires from the carrier board to separation of the dicing wires from the silicon wafer, the wire moving speed of the dicing wires are high, so that a speed of separating the two adjacent silicon wafers 2 can be increased, and efficiency of separating the silicon wafer 2 from the dicing wires 4 can be improved. It should be noted that, because there is a bow in the dicing wires 4, that the dicing wires 4 defined in the present application is located inside the carrier board 3 indicates a state in which at least a part of the dicing wires are located inside the carrier board 3, and that the dicing wires 4 is separated from the carrier board 3 indicates a state in which the dicing wires are entirely separated from the carrier board 3.

In an embodiment, in the process in which the dicing wires 4 moves in the forward direction or the reverse direction when it is determined that the dicing wires 4 is located inside the carrier board 3 in step S310, S1 gradually increases. When the dicing wires 4 is completely located inside the carrier board 3, the speed is low, to avoid the case in which the dicing wires 4 is biased to either of two adjacent silicon wafers 2 due to sway, thereby reducing a probability that the dicing wires 4 hangs up on the side of the silicon wafer 2 that is adhered to the carrier board 3. As the silicon wafer 2 is lifted relative to the dicing wires 4, due to existence of the bow of the dicing wires 4, when the dicing wires 4 is partially located in the silicon wafer 2, referring to FIG. 8, a top of the bow of the dicing wires 4 and a part of the dicing wires 4 close to the top of the bow are located inside the carrier board 3, and the wire moving speed of the dicing wires 4 gradually increases. The dicing wires 4 close to a side on which the dicing wires 4 runs out of the silicon wafer 2 can drive a part of the dicing wires 4 located inside the carrier board 3, and force the part of the dicing wires 4 located inside the carrier board 3 to move to the middle of the two adjacent silicon wafers 2, thereby avoiding the case in which the dicing wires 4 hangs up on the side of the silicon wafer 2 that is adhered to the carrier board 3.

During specific implementation, 3 m/min ≤ S1 ≤ 50 m/min. For example, S1 may be 3 m/min, 10 m/min, 20 m/min, 25 m/min, 30 m/min, 40 m/min, or 50 m/min. S2 ≤ 50 m/min. S2 may be 20 m/min, 25 m/min, 30 m/min, 36 m/min, 42 m/min, 45 m/min, 50 m/min, or the like.

It may be understood that a direction of the bow formed when the dicing wires 4 is bent is the same as a movement direction of the carrier board 3 relative to the dicing wires 4. Specifically, as shown in FIG. 3, in a dicing process, the carrier board 3 drives the silicon rod 1 to move relative to the dicing wires 4 in an up-to-down direction. In this case, the dicing wires 4 is bent downward to form the bow. Therefore, when the dicing wires 4 dices into the carrier board 3, the bow of the dicing wires 4 is in a downward bent state. Referring to FIG. 8 and FIG. 9, when the silicon wafers 2 obtained by dicing the silicon rod 1 are lifted upward relative to the dicing wires 4, the dicing wires 4 is bent upward to form the bow. In this case, to separate the dicing wires 4 from the carrier board 3, in a process of lifting the carrier board 3 upward relative to the dicing wires 4, the bow of the dicing wires 4 gradually changes from being bent downward to being bent upward. To ensure that the dicing wires 4 is switched from the unidirectional motion mode to the bidirectional motion mode in a case in which the dicing wires 4 is completely separated from the carrier board 3, in the process in which the dicing wires move in the forward direction or the reverse direction when it is determined that the dicing wires are located inside the carrier board in step S310, a distance by which the silicon wafer 2 is lifted upward relative to the dicing wires 4 ranges from 15% to 25% of a size of the silicon wafer in a vertical direction. In this way, corresponding to different sizes of silicon wafers, a proper lift distance is selected to ensure that the lift distance enables the dicing wires 4 to be completely separated from the carrier board 3. During specific implementation, the distance by which the silicon wafer 2 is lifted upward relative to the dicing wires 4 may range from 30 mm to 50 mm, and specifically, may be 30 mm, 32 mm, 40 mm, 46 mm, 50 mm, or the like.

In an embodiment, a speed at which the silicon wafer 2 obtained by dicing the silicon rod 1 is lifted upward relative to the dicing wires 4 is any speed ranging from 15 mm/min to 60 mm/min. On one hand, an excessively high speed at which the silicon wafer 2 is lifted upward relative to the dicing wires 4 that results in snapping of the dicing wires 4 or fragments of the silicon wafer 2 is avoided. On the other hand, an excessively low speed at which the silicon wafer 2 is lifted upward relative to the dicing wires 4 that causes a low efficiency of separating the silicon wafer 2 from the dicing wires 4 is avoided.

In an actual case, in the process of lifting the silicon wafer 2 upward relative to the dicing wires 4 in step S300, the dicing method for a silicon wafer provided in this embodiment of the present application further includes step: spraying dicing fluid on the dicing wires 4. The dicing fluid is preferably composite mortar. The composite mortar can reduce an absorption force between the two adjacent silicon wafers 2, and facilitate the dicing wires 4 to separate the two adjacent silicon wafers 2. During specific implementation, the composite mortar includes the dicing fluid and silica fume. Existence of the silica fume can reduce the absorption force between the two adjacent silicon wafers 2, and can implement reuse of the dicing fluid, thereby avoiding a resource waste.

In a possible implementation, in the process in which the dicing wires move in the forward direction and the reverse direction alternately when it is determined that the dicing wires are separated from the carrier board in step S320, the dicing method for a silicon wafer further includes the following step: spraying clear water between the silicon wafers 2. On one hand, the clear water is disposed to wash the silicon wafer 2. On the other hand, the clear water is sprayed between the silicon wafers 2, and a spraying force of the clear water separates the two adjacent silicon wafers 2. A spray flow rate of the clear water is any value ranging from 50 L/min to 300 L/min, to ensure that the spraying force of the clear water can separate the two adjacent silicon wafers 2. For example, the spray flow rate of the clear water may be 50 L/min, 60 L/min, 80 L/min, 100 L/min, 160 L/min, 200 L/min, 245 L/min, 280 L/min, or 300 L/min.

The present application is further described below with reference to specific embodiments.

### Embodiment 1

In Embodiment 1, the dicing wires are wound on surfaces of three dicing rollers to form dicing wires net. Roller grooves of the three dicing rollers are V-shaped grooves. The silicon rod is diced by using the dicing wires net, to dice the silicon rod into silicon wafers. A size of the silicon wafers obtained through dicing is 182.2 mm * 183.75 mm * 0.13 mm, a wire moving speed of the dicing wires are 20 mm/min, and a lifting speed of the silicon wafers is 30 mm/min.

The dicing method for a silicon wafer in Embodiment 1 includes the following steps: first, a silicon rod 1 and a carrier board 3 are provided. Then, the silicon rod 1 is driven to move downward relative to dicing wires 4, to obtain a plurality of silicon wafers 2 by dicing the silicon rod 1 by using the dicing wires 4. In this case, the dicing wires 4 needs to dice into the carrier board, to ensure that the silicon rod 1 is completely diced through. Finally, the silicon wafers 2 are lifted upward relative to the dicing wires 4. When the dicing wires 4 is located on the carrier board 3, a motion mode of the dicing wires are unidirectional lifting. When the dicing wires completely enters the silicon rod, and it is determined that the dicing wires 4 is separated from the carrier board, the dicing wires performs bidirectional lifting, to be specific, alternately moves in a forward direction and a reverse direction. Specifically, a wire moving distance of unidirectional lifting is 4.2 m, and a wire moving distance of bidirectional lifting is 0.6 m.

### Comparative example 1

Different from Embodiment 1, during the entire upward lifting of the silicon wafers, the dicing wires always performs unidirectional lifting in Embodiment 1, and when unidirectional lifting is always performed, a range of a wire moving distance is 17 m. Other parts are the same as those in Embodiment 1.

### Comparative example 2

Different from Embodiment 1, during the entire upward lifting of the silicon wafers, the dicing wires always performs bidirectional lifting in Embodiment 1, and when bidirectional lifting is always performed, a range of a wire moving distance is 0.6 m. Other parts are the same as those in Embodiment 1.

A total of 2000 times of dicing experiments are performed on consoles of 70 dicing machines of a same specification below, and a snapping proportion and an abnormality rate of the silicon wafers in Embodiment 1 and Comparative examples 1 and 2 are respectively recorded. It should be noted that, the abnormality rate of the silicon wafers is a total quantity of abnormal silicon wafers produced in the 2000 times of dicing divided by a total quantity of all produced silicon wafers. The abnormality rate of the silicon wafers mainly refers to a ratio of abnormalities such as scratches and chamfer fragments that occur during the upward lifting of the silicon wafers. For a specific comparison result, refer to Table 1.

**Table 1**

| | Snapping proportion | Abnormality rate of silicon wafers |
|---|---|---|
| The present application | 2.5% | 0.3% |
| Comparative example 1 | 8% | 1% |
| Comparative example 2 | 10% | 0.7% |

It can be learned from Table 1 that the snapping proportion of the dicing wires and the abnormality rate of the silicon wafers can be reduced by using the dicing method for a silicon wafer provided in the present application. Certainly, impact of different types of silicon wafers differs. Generally, as the dicing wires are increasingly thin, and a size of a silicon wafer is increasingly large, the dicing method for a silicon wafer provided in this embodiment of the present application has larger advantages.

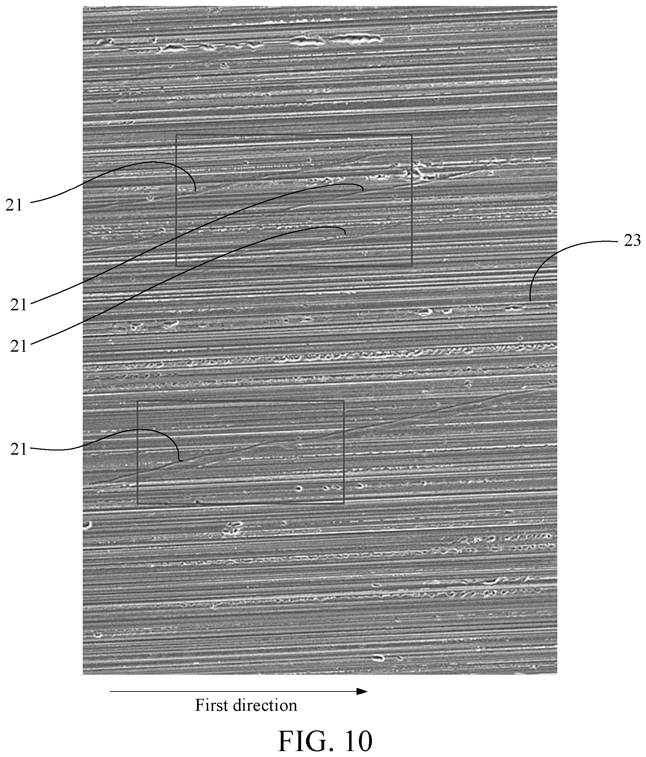

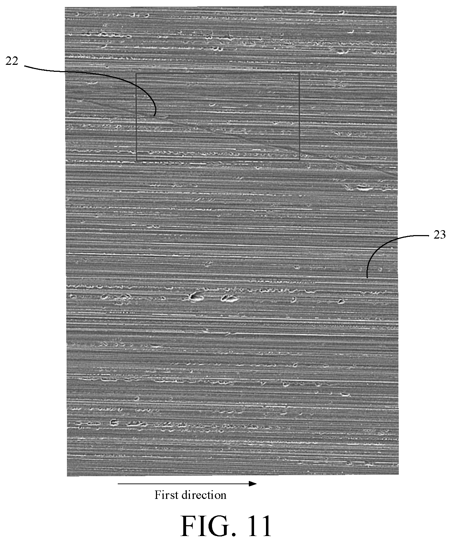

As shown in FIG. 8, FIG. 10, and FIG. 11, according to a third aspect of the present application, an embodiment of the present application further provides a silicon wafer. A silicon wafer 2 has a first group of opposite edges and a second group of opposite edges. The first group of opposite edges includes a first edge 201 and a second edge 202 opposite to each other. FIG. 8 shows that a left side and a right side of the silicon wafer 2 are respectively the first edge 201 and the second edge 202. The second group of opposite edges includes a third edge 203 and a fourth edge 204 opposite to each other. FIG. 8 shows that an upper side and a lower side of the silicon wafer 2 are respectively the third edge 203 and the fourth edge 204. The first edge and/or the second edge intersect with the third edge and/or the fourth edge. The silicon wafer 2 has a plurality of dicing marks 23 and two groups of scratches, that is, a first group 21 of scratches shown in a rectangular frame in FIG. 10 and a second group 22 of scratches shown in a rectangular frame in FIG. 11. The dicing marks 23 extend along the first group of opposite edges of the silicon wafer 2, that is, extend along a direction from the first edge 201 to the second edge 202 of the first group of opposite edges. The figure shows that the dicing marks 23 extend along a horizontal direction. In the two groups of scratches, one group of scratches is inclined toward the third edge 203 of the silicon wafer 2 in a first direction. The first direction is a direction from the first edge 201 to the second edge 202. As shown in FIG. 10, the first edge 201 is located on a left side in FIG. 10 and FIG. 11, the second edge 202 is located on a right side in FIG. 10 and FIG. 11, and the third edge 203 is located in an upper part in FIG. 10 and FIG. 11. The other group of scratches is inclined toward the fourth edge 204 of the silicon wafer 2 in the first direction. As shown in FIG. 11, the fourth edge 204 is located in a lower part in FIG. 10 and FIG. 11.

It should be noted that the dicing marks 23 are formed by dicing a silicon rod 1 by using dicing wires 4. Specifically, the dicing marks 23 are a grinding textures formed on a surface of the silicon wafer through grinding between the dicing wires 4 and the surface of the silicon wafer in a dicing and wire moving process. As shown in FIG. 3, because the silicon rod 1 is fed downward relative to the dicing wires 4, the dicing wires 4 bears a pressure force from the silicon rod 1, the dicing wires 4 is bent to some extent in a feed direction while the dicing wires 4 moves back and forth, and each of the correspondingly formed dicing marks 23 presents an arc shape visible to naked eyes on the surface of the silicon wafer. FIG. 10 and FIG. 11 show a state of the dicing marks 23 on the silicon wafer. It can be seen from the figures that the plurality of dicing marks 23 are densely distributed along a dicing direction. The dicing method for a silicon wafer further includes: After dicing of the silicon wafers, the silicon wafers 2 are lifted upward relative to the dicing wires 4. During the upward lifting of the silicon wafers 2, because the dicing wires 4 and the silicon wafers 2 contact with each other to different degrees, scratches are formed on the silicon wafers 2, that is, the scratches are marks formed by contact between the silicon wafers 2 obtained through dicing and the dicing wires 4 when the silicon wafers 2 are lifted upward relative to the dicing wires 4. Each group of scratches includes one, two, or a small quantity of scratches, and each scratch in a same group of scratches has a same inclined orientation relative to the dicing marks 23, that is, each scratch is inclined upward or downward relative to the dicing marks 23 along a left-to-right direction shown in FIG. 10 and FIG. 11.

It may be understood that, that the first edge and/or the second edge intersect with the third edge and/or the fourth edge in the present application may be intersecting with each other after being connected by using chamfers, or may be intersecting with each side by edges or extension lines thereof. For example, for a silicon wafer of a polygon or another shape, this is not limited in this embodiment of the present application.

When the foregoing technical solution is used, both the two groups of scratches on the silicon wafer are formed by scratching the silicon wafer by the dicing wires when the silicon wafer is lifted upward relative to the dicing wire. One group of scratches is formed by randomly scratching the surface of the silicon wafer when the dicing wires move along one direction. For example, the first group 21 of scratches is formed by scratching the surface of the silicon wafer when the dicing wires move in the forward direction between the silicon wafers. The other group of scratches is formed by randomly scratching the surface of the silicon wafer when the dicing wires move along another opposite direction. For example, the second group 22 of scratches is formed by scratching the surface of the silicon wafer when the dicing wires reversely moves between the silicon wafers. When the dicing wires move, the silicon wafer is lifted upward relative to the dicing wire. Therefore, the two groups of scratches are respectively formed by scratching corresponding to twice motion of the dicing wires in opposite directions. One group of scratches is inclined, in the first direction relative to the dicing marks 23, toward the third edge 203 of the silicon wafer, and the other group of scratches is inclined, in the first direction relative to the dicing marks 23, toward the fourth edge 204 of the silicon wafer opposite to the third edge 203. Because dicing and slicing operations of the silicon wafer are performed according to the dicing method for a silicon wafer in the present application, a phenomenon of scratches on the surface of the silicon wafer is reduced, and a damage caused by the dicing wires to the silicon wafer is reduced. For details, refer to beneficial effects in the method, and details are not described herein again.

In some embodiments, angles between the scratches and the dicing mark 23 are less than 20°. For example, the angle may be 1°, 5°, 10°, 15°, or 19°. Angles between scratches in a same group of scratches and the dicing mark 23 may be the same or different. The angle refers to an angle between the scratch and a tangent line on the dicing mark 23. The tangent line is a tangent line passing through an intersection point of the scratch and the dicing mark 23. The dicing mark 23 is overall slightly arc-shaped. However, from a local view having the scratch, the dicing mark 23 in the local view may be considered as a substantially straight line, and the scratch may also be considered as a substantially straight line.

The angle is related to a speed at which the silicon wafer is lifted upward and a wire moving speed of the dicing wire. A higher speed indicates a larger angle between the scratch and the dicing mark, higher slicing efficiency, and more scratches and more damages on the silicon wafer. Therefore, to ensure the slicing efficiency of the silicon wafer and reduce the scratches and damages on the silicon wafer, a suitable speed is selected. For a specific speed, refer to related descriptions in the method. At this speed, the angles between the scratches formed on the silicon wafer and the dicing mark 23 are less than 20°.

In some embodiments, depths of the scratches range from 2 µm to 17 µm, and specifically, may be 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, or the like. The depths of the scratches on the surface of the silicon wafer obtained by using the foregoing method are small, to help improve a surface passivation effect of a solar cell prepared subsequently, and improve photoelectric conversion efficiency.

In some possible implementations, the two groups of scratches are located on a same surface of the silicon wafer, and/or the two groups of scratches are respectively located on two opposite surfaces of the silicon wafer. Because the scratches formed by the dicing wires on the silicon wafer are random, the scratches may be formed on only one surface of the silicon wafer, or the scratches may be formed on both side surfaces of the silicon wafer. When the scratches are formed on only one surface of the silicon wafer, there are two groups of scratches on the surface, including the first group 21 of scratches and the second group 22 of scratches. When the scratches are formed on the both side surfaces of the silicon wafer, one surface may have only one group of scratches (for example, the first group 21 of scratches), and the other surface may have only the other group of scratches (for example, the second group of scratches). Alternatively, one surface has only one group of scratches, for example, the first group 21 of scratches or the second group 22 of scratches, and the other surface simultaneously has the two groups of scratches. Alternatively, both the surfaces simultaneously have the two groups of scratches.

It should be noted that, that the different groups of scratches are inclined to different orientations refers to that the first group 21 of scratches and the second group 22 of scratches are inclined to different orientations, and scratches of a same group are inclined to a same orientation.

In the descriptions of the foregoing implementations, the described specific features, structures, materials, or characteristics may be combined in a proper manner in any one or more of the embodiments or examples.

In conclusion, in the provided dicing method for a silicon wafer in this embodiment, the silicon rod is first diced by using the dicing wire. After the silicon rod is diced into the silicon wafers, the silicon wafers are controlled to be lifted upward. In the process of controlling to lift the silicon wafers upward, the dicing wires are controlled to cyclically move in the forward direction and the reverse direction alternately. The contact area between the silicon wafer and the dicing wires are smaller, due to the feature that the bow when the wire moves in the forward direction and the reverse direction is less than a bow when the wire unidirectionally moves, so that not only a probability that the dicing wires forms the scratches on the silicon wafers during the upward lifting of the silicon wafers, but also a case in which the silicon wafers are dropped when the silicon wafers are lifted upward can be reduced. In addition, there are advantages of a high lifted upward acceleration, high surface quality of the produced silicon wafers, and a small secondary damage. In addition, the different motion modes of the dicing wires when the dicing wires are located inside the carrier board and after the dicing wires are separated from the carrier board are selected based on the actual lifting environment of whether the dicing wires are located inside the carrier board or the dicing wires are located between the silicon wafers, so that the damage of the dicing wires to the silicon wafer is further reduced.

Although preferred embodiments of the embodiments of the present application have been described, persons skilled in the art can make other changes and modifications to these embodiments once they know the basic creative concept. Therefore, the following claims are intended to cover the preferred embodiments and all changes and modifications falling within the scope of the embodiments of the present application.

The dicing method for a silicon wafer and the silicon wafer provided in the present application are described above in detail. Although the principles and implementations of the present application are described by using specific examples in this specification, the descriptions of the foregoing embodiments are only used to help understand the method and core ideas of the present application. A person of ordinary skill in the art may make modifications to the specific implementations and application range according to the ideas of the present application. In conclusion, the content of this specification is not construed as limitation on the present application.

## Claims

1. A dicing method for a silicon wafer, wherein the method comprises:
providing a silicon rod and a carrier board;
driving the silicon rod to move downward relative to dicing wires, to obtain a plurality of silicon wafers by dicing the silicon rod by using the dicing wire; and
lifting the silicon wafers upward relative to the dicing wire, and controlling the dicing wires in contact with the silicon wafers to cyclically move in a forward direction and a reverse direction alternately during the lifting of the silicon wafers.

2. The dicing method for a silicon wafer according to claim 1, wherein the controlling the dicing wires in contact with the silicon wafers to cyclically move in a forward direction and a reverse direction alternately comprises:
in a direction switching phase, controlling the dicing wires to switch a movement direction within 0s to 0.5s, and accelerate to any speed ranging from 0.01 m/s to 1 m/s within 4s to 7s; and
in a non-direction switching phase, controlling the dicing wires to move at any constant speed ranging from 0.01 m/s to 1 m/s.

3. The dicing method for a silicon wafer according to claim 1, wherein a distance by which the dicing wires move in the forward direction and a distance by which the dicing wires move in the reverse direction are the same in each cycle of alternation between the forward direction and the reverse direction.

4. The dicing method for a silicon wafer according to claim 3, wherein a distance by which the dicing wires move in the forward direction or the reverse direction is any value ranging from 0.05 m to 30 m in each cycle of alternation between the forward direction and the reverse direction.

5. The dicing method for a silicon wafer according to claim 1, wherein the lifting the silicon wafers upward comprises:
determining a feed speed based on a height by which the silicon wafers are to be lifted upward, wherein feed speeds corresponding to different lifting heights are at least partially different; and
controlling to lift the silicon wafers upward at the feed speed.

6. The dicing method for a silicon wafer according to claim 5, wherein before the determining a feed speed based on a height by which the silicon wafers are to be lifted upward, the method further comprises:
determining a correspondence between heights by which the silicon wafers are to be lifted upward and feed speeds, wherein in the correspondence, the feed speeds corresponding to different lifting heights are at least partially different, to homogenize scratches formed by the dicing wires on the silicon wafers when the silicon wafers are controlled to be lifted upward at the feed speed determined based on the correspondence; and
the determining a feed speed based on a height by which the silicon wafers are to be lifted upward comprises:
determining the feed speed based on the height by which the silicon wafers are to be lifted upward and the correspondence.

7. The dicing method for a silicon wafer according to claim 5, wherein the process of lifting the silicon wafers upward comprises a start phase, an intermediate phase, and an end phase in sequence; and
the determining a feed speed based on a height by which the silicon wafers are to be lifted upward comprises:
controlling a first feed speed of the silicon wafers to be less than a second feed speed of the silicon wafers, wherein the first feed speed is a speed at which the silicon wafers lift upward in the start phase, and the second feed speed is a speed at which the silicon wafers are lifted upward in the intermediate phase; and
controlling a third feed speed of the silicon wafer to be greater than or equal to the second feed speed, wherein the third feed speed is a speed at which the silicon wafers are lifted upward in the end phase.

8. The dicing method for a silicon wafer according to claim 7, wherein the first feed speed is any speed ranging from 20 mm/min to 40 mm/min, the second feed speed is any speed ranging from 40 mm/min to 80 mm/min, and the third feed speed is any speed ranging from 80 mm/min to 600 mm/min.

9. The dicing method for a silicon wafer according to claim 1, wherein the method further comprises:
lifting the silicon wafers upward relative to the dicing wire, wherein a motion mode of the dicing wires when the dicing wires are located inside the carrier board is different from a motion mode of the dicing wires after the dicing wires are separated from the carrier board.

10. The dicing method for a silicon wafer according to claim 9, wherein that a motion mode of the dicing wires when the dicing wires are located inside the carrier board is different from a motion mode of the dicing wires after the dicing wires are separated from the carrier board comprises:
when the dicing wires are located inside the carrier board, the dicing wires move in the forward direction or the reverse direction; and when the dicing wires are separated from the carrier board, the dicing wires cyclically moves in the forward direction and the reverse direction alternately.

11. The dicing method for a silicon wafer according to claim 10, wherein in a process in which the dicing wires cyclically moves in the forward direction and the reverse direction alternately, the dicing wires alternately moves in the forward direction and the reverse direction, a distance by which the dicing wires move in the forward direction is any value ranging from 0.05 m to 0.2 m, and a distance by which the dicing wires move in the reverse direction is any value ranging from 0.05 m to 0.2 m.

12. The dicing method for a silicon wafer according to claim 11, wherein the distance by which the dicing wires move in the forward direction and the distance by which the dicing wires move in the reverse direction are the same in a process in which the dicing wires alternately moves in the forward direction and the reverse direction.

13. The dicing method for a silicon wafer according to claim 11, wherein when the dicing wires are located inside the carrier board, an average wire moving speed at which the dicing wires move in the forward direction or the reverse direction in a process in which the dicing wires move in the forward direction or the reverse direction is S1; and
when the dicing wires are separated from the carrier board, a maximum wire moving speed at which the dicing wires move in the forward direction or the reverse direction in a process in which the dicing wires alternately moves in the forward direction and the reverse direction is S2, and S1 < S2.

14. The dicing method for a silicon wafer according to claim 13, wherein when it is determined that the dicing wires are located inside the carrier board, a wire moving speed of the dicing wires gradually increases in the process in which the dicing wires move in the forward direction or the reverse direction.

15. The dicing method for a silicon wafer according to claim 13, wherein 3 m/min ≤ S1 ≤ 50 m/min, and/or S2 ≤ 50 m/min.

16. The dicing method for a silicon wafer according to claim 9, wherein a speed at which the silicon wafers are lifted upward relative to the dicing wires are any speed ranging from 15 mm/min to 60 mm/min.

17. A silicon wafer, having a first group of opposite edges and a second group of opposite edges, wherein the first group of opposite edges comprises a first edge and a second edge opposite to each other, the second group of opposite edges comprises a third edge and a fourth edge opposite to each other, the first edge and/or the second edge intersect with the third edge and/or the fourth edge, and the silicon wafer has two groups of scratches, wherein
one group of scratches is inclined toward the third edge in a first direction, the other group of scratches is inclined toward the fourth edge in the first direction, and the first direction is a direction from the first edge to the second edge.

18. The silicon wafer according to claim 17, wherein an angle between the scratch and a dicing mark is less than 20°.

19. The silicon wafer according to claim 17, wherein depths of the scratches are any value ranging from 2 µm to 17 µm.

20. The silicon wafer according to any one of claims 17 to 19, wherein the two groups of scratches are located on a same surface of the silicon wafer, and/or the two groups of scratches are respectively located on two opposite surfaces of the silicon wafer.
